# EUROPEAN PATENT APPLICATION

(11) **EP 1 605 498 A1**
(43) Date of publication of application: **14.12.2005**
(21) Application number: 04291473.9
(22) Date of filing: 11.06.2004
(51) Int. Cl.: H01L 21/20

(54) **A method of manufacturing a semiconductor wafer**

(71) Applicant: S.O.I. Tec Silicon on Insulator Technologies S.A., 38190 Bernin (FR)
(72) Inventor: Maleville, Christophe, 38660 La Terrasse (FR); Arène, Emmanuel, 38330 Biviers (FR)
(74) Representative: Grünecker, Kinkeldey, Stockmair & Schwanhäusser Anwaltssozietät

(57) **Abstract**

The present invention relates to a method of manufacturing a wafer comprising a substrate of a single crystalline first material and at least one layer of a second material which is epitaxially grown on the first material, and which has a lattice different from the lattice of the first material. It is therefore the object of the present invention to provide a method of the above-mentioned type with which a wafer with a good quality of the epitaxial layer which is grown on a substrate with a different lattice can be obtained. The object is solved by a method of the above-mentioned type characterised in that growing of the second material is performed without a final surface polishing of the substrate.

## Description

The present invention relates to a method of manufacturing a wafer comprising a substrate of a single crystalline first material and at least one layer of a second material which is epitaxially grown on the first material, and which has a lattice different from the lattice of the first material.

Heteroepitaxial layers such as SiGe layers grown on single crystalline substrates such as silicon enjoy an increasing popularity for manifold applications in semiconductor technology. However, due to the difference in lattice between the substrate and the heteroepitaxially grown layer, misfit and associated threading dislocations are formed during growth of the heteroepitaxial layer.

One approach to producing defect-free heteroepitaxial layers is the growth of a graded buffer layer of GeSi on a silicon substrate wherein the germanium percentage of the GeSi layer is gradually increased starting from the substrate. The increase can go up to 100% germanium or below. Grading up of a heteroepitaxial layer stack, however, results in a high degree of surface roughness and waviness of the resulting structures. In particular, the surface of such a structure is highly degraded by the so-called "crosshatch" phenomenon caused by a stress release during growth of the heteroepitaxial GeSi layer.

Since a controlled surface nanotopography and low roughness are key issues in utilising heteroepitaxial structures for integrated circuits, the rough and wavy surface of the heteroepitaxial GeSi layer must be planarised to remove surface nanotopography and must be further polished by a chemical-mechanical polishing (CMP) step to perfect surface roughness by keeping surface nanotopography at the same level. It is very difficult to balance the effects of planarisation and polishing since geometry and surface nanotopography properties of the structure will be degraded by polishing.

US 6,039,803 shows a method for improvement in the surface roughness and reduction of the dislocation pile-up density of a heteroepitaxial layer by growing such a layer on a miscut silicon substrate. The miscut substrate has a crystallographic orientation off-cut to an orientation from about 1° to about 8° offset from the [001] direction. Such substrates are not commonly available and are therefore too costly to have relevance in heteroepitaxial layer manufacturing.

It is therefore the object of the present invention to provide a method of the above-mentioned type with which a wafer with a good quality of the epitaxial layer which is grown on a substrate with a different lattice can be obtained.

The object is solved with a method of the above-mentioned type characterised in that growing of the second material is performed before a final surface finishing of the substrate.

Surprisingly, the unready surface of the substrate before final surface finishing helps to bond first atoms of the second material on the substrate so that appropriate adhesion properties for the epitaxial layer of the second material can be achieved. Therefore, the epitaxial layer of the second material can be grown right from the start on the substrate with less stress, resulting in a high quality epitaxial layer of the second material on the first material despite the different lattices of these materials.

Due to the inventive idea of growing the second material before the final surface finishing step, the process time and costs for the final surface finishing of the substrate can be reduced, leading to a reduction of process time and costs of the whole heteroepitaxial layer manufacturing process.

In an advantageous embodiment of the invention, the second material is grown before a final step of polishing of the substrate. Surprisingly, the rough surface of the substrate before the final polishing step provides a very good basis for good adhesion and high quality growth of the second material on the first material. This allows the reduction of process time and costs of heteroepitaxial wafer manufacturing but results in excellent properties of the wafers produced.

In a favourable variant of the invention, the second material is grown on an on-axis silicon substrate. Due to the inventive method, conventionally available on-axis, non-miscut substrates can be utilised, making the inventive process very attractive for mass production of heteroepitaxial wafers.

It is furthermore advantageous to grow the second material on a surface of a substrate which has a higher roughness and/or defect density than a mirror-polished substrate. It has been shown that in spite of the excellent surface quality of a mirror-polished substrate, the second material grows more easily and with lower stress on a substrate with a higher roughness and/or defect density.

In a favourable example of the invention, the second material is grown on a substrate having a surface roughness of about 0.15 to about 0.4 nanometers RMS. This range of surface roughness is especially effective for a low-stress growth of the second material on the first material.

In a beneficial embodiment of the invention, the second material is grown on a substrate having a surface defect density of about 0.2 to about 1 defects with a size of more than 0.12 micrometers per square millimetres. Surprisingly, the defects can be helpful in establishing a better start layer of the second material.

Specific embodiments of the present invention will become more apparent from the following detailed description with reference to the accompanying drawings, wherein:
- Fig. 1: schematically shows a process sequence according to a first embodiment of the invention;
- Fig. 2: schematically shows a substrate utilised in the present invention;
- Fig. 3: schematically shows the substrate of Fig. 2 after growth of a graded buffer layer;
- Fig. 4: schematically shows the structure of Fig. 3 after growth of a relaxed layer;
- Fig. 5: schematically shows the structure of Fig. 4 after CMP stock removal and surface finishing;
- Fig. 6: schematically shows a method according to a second embodiment of the present invention;
- Fig. 7: schematically shows the structure of Fig. 5 after an implantation step of a method according to the second embodiment of the present invention;
- Fig. 8: schematically shows the structure of Fig. 7 after a bonding step of a method according to the second embodiment of the present invention;
- Fig. 9: schematically shows an as-cut part of the structure of Fig. 8 after cutting of the structure of Fig. 7 according to the second embodiment of the present invention;
- Fig. 10: schematically shows the structure of Fig. 9 after a re-growth of the split layer according to the second embodiment of the present invention;
- Fig. 11: schematically shows the structure of Fig. 10 after surface finishing of the regrown epitaxial layer of Fig. 10 according to the second embodiment of the present invention;
- Fig. 12: schematically shows another as-cut part of the structure of Fig. 8 after cutting of the structure of Fig. 8 according to the second embodiment of the present invention;
- Fig. 13: schematically shows the structure of Fig. 12 after a re-growth of the split layer of Fig. 12 according to the second embodiment of the present invention;
- Fig. 14: schematically shows the structure of Fig. 13 after finishing of the re-grown layer of Fig. 13 according to the second embodiment of the present invention.

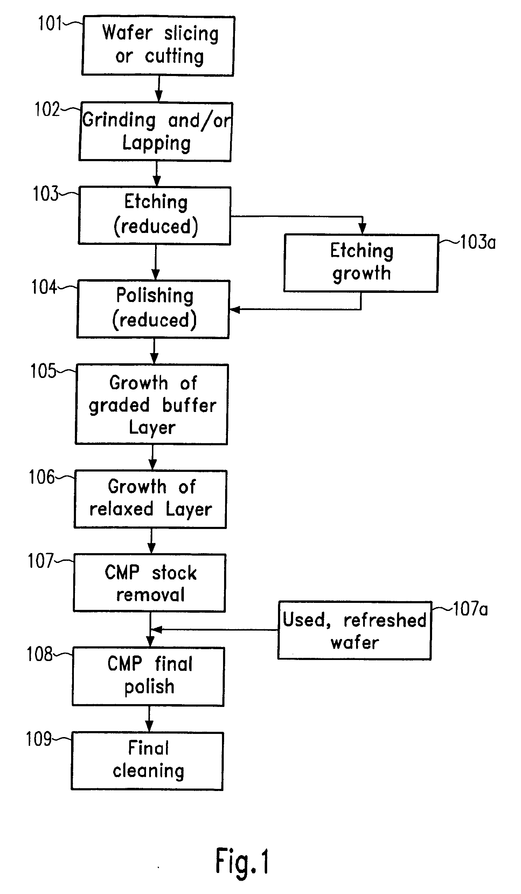

Fig. 1 schematically shows a process sequence of a method according to a first embodiment of the present invention.

Step 101 includes wafer slicing or wafer cutting resulting in thin slices or wafers of a specific thickness and warpage from a single crystal ingot. The wafers can be sliced, for instance, by using an internal diameter blade or by a wire saw using a fine, high tensile wire as a medium carrying abrasive slurry abrading through an ingot. The ingot and the sliced wafers are preferably of silicon but can also be of another single crystalline material like germanium.

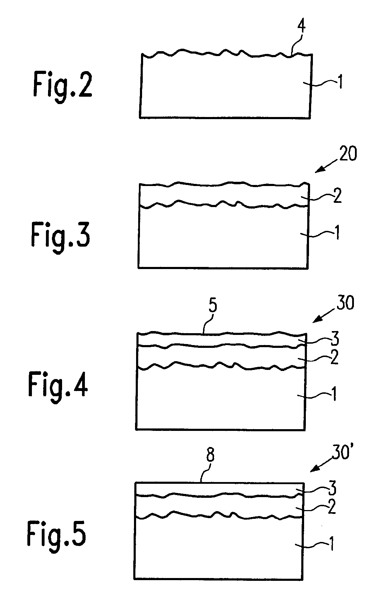

With reference to step 102, at least one wafer 1 of the wafers which have been sliced in step 101 is ground and/or lapped. Grinding can involve an edge grinding to round-up the wafer's edge using a diamond-plated wheel which grinds the edge of the sliced or as-cut wafer 1 which is, for instance, shown in Fig. 2.

In step 102 in Fig. 1, the wafer 1 can also be lapped between two lapping plates to remove physical irregularities or crystal damage layers left by slicing. Lapping creates a flat surface and uniform thickness of the wafer 1.

Grinding and lapping can be used alternatively. 300 mm wafers are favourably only grinded to provide a good flatness of the wafers. Wafers of other sizes, such as of 200 mm in size, should be favourably produced inclusive of a lapping step.

In step 103 of Fig. 1, the lapped or ground wafer 1 is chemically etched. The wafer 1 is favourably immersed and rotated in a chemical bath with precisely controlled parameters to remove a layer from the lapped or ground wafer 1 which has been damaged during the grinding or lapping step 102. Besides etching, step 103 further includes cleaning, rinsing, drying, etc. In comparison with a conventional etching step performed in general processes of wafer manufacturing, step 103 of the present invention includes a reduced alkaline etching so that the surface of the etched wafer 1 can be further damaged, in comparison to a damage-free, perfect crystal structure on the surface which is produced by an etching step of a conventional wafer manufacturing method. According to an option of the invention, epitaxial growth can be applied, as shown in step 103a of Fig. 1, after etching step 103. In this stage of the process, the wafer has a better flatness than after the following double-side polishing step.

Step 104 in Fig. 1 shows a polishing step using chemical-mechanical polishing (CMP). In comparison with conventional wafer manufacturing, the polishing step 104 is performed in a reduced manner. That means that the wafer 1 has an increased surface roughness after the polishing step 104, as shown by the increased roughness of surface 4 of the wafer 1 in Fig. 2. The surface roughness of the wafer 1 after the polishing step 104 is between about 0.15 and 0.3 nanometres RMS. The surface defect density of the substrate after step 104 is about 0.2 to 1 defects with a size of more than 0.12 micrometers per square millimetres. That corresponds to a defect density for 8-inch and 300-mm wafers of an order of 100 defects of a size of more than 0.12 micrometers per wafer. For comparison, the defect density of high quality SOI (silicon-on-insulator) wafers is typically about 25 defects of a size of more than 0.13 micrometers per 8-inch or 300-mm wafer.

In a conventional wafer manufacturing process, after etching and polishing there would follow a chemical-mechanical polishing process may be in several steps to produce a super-flat mirror surface which is microscopically smooth and free from any surface damage or imperfection like scratches, to cater for the most stringent IC fabrication requirements.

In contrast, in the present invention, in step 105 a graded buffer layer 2, which is shown in Fig. 3, is grown on the Wafer 1 which forms a substrate 4 of the graded buffer layer 2. Defects on and/or roughness of the surface 4 form a good basis for a support of bonding of first atoms of the graded buffer layer 2 on the wafer 1. In this way, a start layer of the graded buffer layer 2 can be easily formed while stress in the first atomic layers of the graded buffer layer 2 on the wafer 1 can be minimised. The unready surface 4 of the wafer 1 provides appropriate adhesion properties for the growth of the epitaxial graded buffer layer 2. As an option, crystal orentation can be slightly off areis to help epitaxial grwoth. As a result, the wafer 1 forms a very good starting material for high quality epitaxial growth of the graded buffer layer 2. This is a surprising effect since conventionally, high quality layers are grown on high quality substrates with super-flat and damage-free mirror surfaces.

In the embodiment shown, the graded buffer layer 2 is a graded SiGe layer 2, the germanium content of which is gradually increased starting from the wafer 1 up to about 100% germanium, or optionally less, e.g. 20% germanium. Any material which is lattice-mismatched with the substrate, such as AsGa, GaN or germanium, can be used instead of SiGe.

In step 106, a relaxed layer such as a relaxed SiGe layer 3, as shown in Fig. 4, is grown on the graded buffer layer 2. The relaxed layer 3 has a very good crystallinity but an increased surface roughness of its surface 5.

In step 107, which follows step 106 in the first embodiment of the invention, a CMP (chemical-mechanical polishing) stock removal is performed on the relaxed layer 3. In step 107, a material thickness, might be 500 nanometres to several µm, is removed from the surface 5 of the relaxed layer 3.

Referring to step 107a of Fig. 1, according to an option of the invention, a used wafer, for instance a donor wafer that is resulting after transfer of a layer according to Smart Cut technology which has slightly better surface quality than wafers used for the first time, is refreshed and can be included in the process just between the CMP stock removal in step 107 and before CMP final polish in step 108. Steps to refresh a used wafer are exemplarily shown in EP 1 156 531 A1. Step 107a can also include regrowth of the relaxed layer 3.

In step 108, there follows a final CMP-polishing of the relaxed layer 3, forming a surface of the relaxed layer 3 with a roughness lower than 0.2 nanometres RMS in 1 by 1 micron scan.

In a final cleaning step 109, physical and ionic contamination such as microscopic particles and metallic/non-metallic residues are removed to create a very clean surface 8, as shown in Fig. 5.

Fig. 2 schematically shows the wafer or substrate 1 after step 104 of Fig. 1, where an as-ground or as-lapped wafer is treated with a reduced etching and polishing step in steps 103 and 104. The surface 4 of the wafer 1 has an increased roughness and an increased surface defect density.

Fig. 3 schematically shows the wafer of Fig. 2 after step 105 of Fig. 1, where the graded buffer layer 2 is grown on the wafer 1 forming wafer 20. The material of the graded buffer layer 2 is different from the material of the wafer substrate 1. Despite the rough and defect- containing surface 4 of the wafer 1, the graded buffer layer 2 forms with a very good crystallinity and with nearly no defects on wafer 1.

Fig. 4 schematically shows the wafer 20 of Fig. 3 after step 106 of Fig. 1 forming wafer 30. In step 106, the relaxed layer 3 is grown epitaxially and with very good crystallinity on the graded buffer layer 2. The surface 5 of the relaxed layer 3 has an increased surface roughness.

Fig. 5 schematically shows the structure 30 of Fig. 4 after steps 107, 108 and 109 of Fig. 1. The resulting structure 30' has a flat and smooth surface 8.

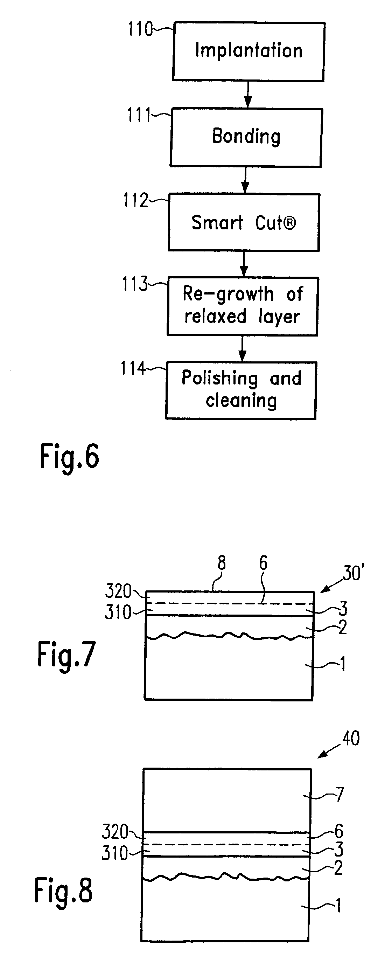

Fig. 6 schematically shows a process sequence of a method according to a second embodiment of the present invention. The steps 110 to 113 of Fig. 6 follow the steps 101 to 109 of Fig. 1. Step 110 of Fig. 6 shows an implantation step which is made in the relaxed layer 3, forming a weakened region 6 in the relaxed layer 3, as shown in Fig. 7. The weakened region 6 divides the relaxed layer 3 into two parts 310, 320.

Step 111 includes a bonding step of the wafer 30' shown in Fig. 7, with a handle wafer 7, such as a silicon wafer. Bonding is performed between a mirror-flat surface of the handle wafer 7 and the polished and cleaned surface 5 of the relaxed layer 3.

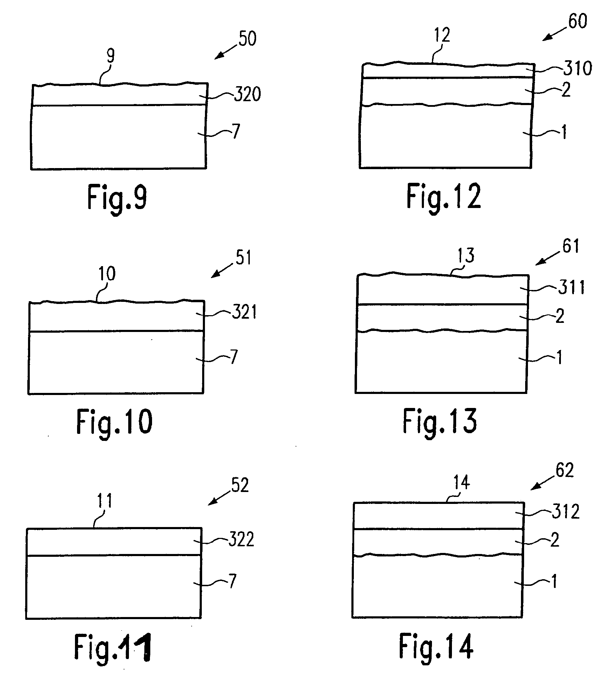

In step 112, which is a so-called "Smart-cut® process" step, a certain amount of energy such as mechanical, thermal, acoustic or optic energy is applied to the bonded structure 40 of Fig. 8, resulting in splitting or cutting of the bonded wafer compound 40 into two parts, which are shown as wafers 50 and 60 in Figs. 9 and 12.

On top of the structures 50, 60 lie, respectively, layer parts 310, 320 of the former relaxed layer 3. Due to splitting, the as-cut surfaces 8, 11 of the wafers 50, 60 have an increased surface roughness.

In step 113 of Fig. 6, the relaxed layer parts 310, 320 of wafer 50, 60 are re-grown to a higher thickness resulting in wafers 51, 61 with thicker relaxed layers 321,311. In step 114 of Fig. 6, the surfaces 10, 13 of the structures 51, 61 in Figs. 10, 13 are polished with a CMP process and cleaned thereafter, resulting in smooth and nearly defect-free surfaces 11, 14 of wafer structures 52, 62 shown in Figs. 11 and 14.

Fig. 7 schematically shows the wafer 30 of Fig. 5 after the implantation step 110 of Fig. 6, resulting in the wafer 30' with the weakened region 6 in the relaxed layer 3.

Fig. 8 schematically shows the wafer 30' of Fig. 7 after the bonding step 111 of Fig. 6 where the wafer 30' has been bonded together with the handle wafer 7 resulting in the bonded wafer compound 40.

Figs. 9 and 12 show parts of the wafer compound 40 of Fig. 8 after splitting which has been done in step 112 of Fig. 6. During the splitting step 112, the wafer compound 40 splits along the weakened region 6 which forms a predetermined splitting line. The surfaces 8, 11 of wafers 50, 60 of Figs. 9 and 12 are produced by the splitting step and are therefore relatively rough. The wafer 50 consists of the handle wafer 7 and the split part 320 of the former relaxed layer 3. The wafer 60 of Fig. 12 consists of the wafer or substrate 1, the graded buffer layer 2 and the split relaxed layer part 310.

Figs. 10 and 13 schematically show the wafers of Figs. 9 and 12 after a re-growth of the relaxed layer parts 320, 310 up to the thicker relaxed layer parts 321, 311.

Figs. 11 and 14 schematically show the wafers 51, 61 of Figs. 10 and 13 after polishing and cleaning resulting in the flat and nearly defect-free surfaces 11, 14 of the final wafer structures 52, 62.

With regard to all process steps shown in Figs. 1 and 6 it should be considered that the steps only represent characteristic steps of the complete process flow and do not claim to be the only steps which can be used. Between the steps, further steps such as cleaning, handling, annealing and layer deposition steps can be applied. A non-graded layer can also be grown on the wafer 1 instead of the graded buffer layer 2, but it should be considered that the layer 2, whatever its material, should be of a material other than the material of the wafer or substrate 1.

In all possible process flows, the growth of the layer 2 is performed on an unready substrate which differs in regard to its surface quality from conventionally available wafers with their mirror-polished surfaces.

## Claims

1. A method of manufacturing a wafer (52, 62) comprising a substrate (1) of a single crystalline first material and at least one layer (2, 3) of a second material which is epitaxially grown on the first material and which has a lattice different from the lattice of the first material
**characterised in that**
growing of the second material is performed before a final surface finishing step of the substrate (1).

2. The method of claim 1
**characterised in that**
the second material is grown before a final step of polishing of the substrate (1).

3. The method of at least one of claims 1 or 2
**characterised in that**
the second material is grown on an on-axis silicon substrate.

4. The method of at least one of the preceding claims
**characterised in that**
the second material is grown on a surface (4) of the substrate (1) which has a higher roughness and/or defect density than a mirror-polished substrate.

5. The method of claim 4
**characterised in that**
the second material is grown on a substrate (1) having a surface roughness of about 0.15 to about 0.4 nanometers RMS.

6. The method of at least one of claims 3 or 4
**characterised in that**
the second material is grown on a substrate (1) having a surface defect density of about 0.2 to about 1 defects of more than 0.12 micrometers in size per square millimeter.

## Amended claims

### Amended claims in accordance with Rule 86(2) EPC.

**1.** A method for manufacturing a wafer (52, 62) comprising a substrate (1) of a single crystalline first material and at least one layer (2, 3) of a second material which is epitaxially grown on the first material and which has a lattice different from the lattice of the first material
**characterised in that**
growing of the second material is performed between an etching step (103) or a polishing step (104), which is performed on an unready surface (4) of a just sliced and lapped and/or ground substrate (1) in a reduced manner resulting in a surface roughness of the substrate (1) of about 0.15 to about 0.4 nanometres RMS, and a final polishing step (108) forming a finished surface (8) of the at least one heteroepitaxial layer (2, 3) with a surface roughness lower than 0.2 nanometres RMS in 1 by 1 micron scan.

**2.** The method of claim 1
**characterised in that**
growing of the second material comprises growing a graded buffer layer (2) and a relaxed layer (3) formed thereon.

**3.** The method of claim 2
**characterised in that**
growing of the graded buffer layer (2) comprises growing of a graded SiGe layer, the germanium content of which is gradually increased starting from the substrate (1).

**4.** The method of at least one of the claims 2 or 3
**characterised in that**
a material thickness of the relaxed layer (3) is removed by a CMP stock removal step (107) applied before performing the final polishing step (108).

**5.** The method of at least one of the preceding claims
**characterised in that**
the second material is grown on an on-axis silicon substrate.

**6.** The method of claim 1
**characterised in that**
the second material is grown on the substrate (1) having a surface defect density of about 0.2 to about 1 defects of more than 0.12 micrometers in size per mm².

**7.** A wafer (52, 62) comprising a substrate (1) of a single crystalline first material and at least one layer (2, 3) of a second material which is epitaxially grown on the first material and which has a lattice different from the lattice of the first material
**characterised in that**
a surface of the substrate (1) on which the at least one layer (2, 3) of the second material is grown is an unready surface (4) of a just sliced and lapped and/or ground substrate (1) and has a surface roughness of about 0.15 to about 0.4 nanometres RMS, and a surface (8) of the at least one heteroepitaxial layer (2, 3) is polished and has a roughness lower than 0.2 nanometres RMS in 1 by 1 micron scan.

**8.** The wafer of claim 7
**characterised in that**
the at least one heteroepitaxial layer (2, 3) comprises a graded buffer layer (2) and a relaxed layer (3) formed thereon.

**9.** The wafer of claim 8
**characterised in that**
the graded buffer layer (2) comprises a graded SiGe layer, the germanium content of which is gradually increasing starting from the substrate (1).

**10.** The wafer of one of the claims 1 or 7
**characterised in that**
the first material is of silicon or germanium, and the second material is of SiGe, AsGa, GaN or germanium.
